# DEMANDE DE BREVET EUROPEEN

(11) **EP 4 742 882 A1**
(43) Date de publication de la demande: **13.05.2026**
(21) Numéro de dépôt: 25211136.4
(22) Date de dépôt: 24.10.2025
(51) Int. Cl.: H10P 74/00, H10W 42/00

(54) **PUCE ELECTRONIQUE COMPORTANT UN DISPOSITIF DE DETECTION DE FISSURES**

(30) Priorité: 06.11.2024 FR 2412129
(71) Demandeur: STMicroelectronics International N.V., 1228 Plan-les-Ouates, Geneva (CH)
(72) Inventeur: JOUAN, Gregoire, 38500 VOIRON (FR)
(74) Mandataire: Cabinet Beaumont

(57) **Abrégé**

La présente description concerne une puce électronique comprenant un dispositif de détection de fissures formé dans et sur un substrat ou sur le substrat, le dispositif comportant un chemin conducteur comportant une alternance de bandes conductrices inférieures (201) et supérieures (203),
le chemin comprenant, pour chaque bande inférieure : un premier (205A) et un deuxième (205B) vias conducteurs en contact avec la bande inférieure, un troisième (207A) et un quatrième (207B) vias conducteurs en contact avec respectivement une bande et une autre bande supérieure, au moins une première (209A) et une deuxième (209B) pistes conductrices connectant respectivement les premier et troisième vias et les deuxième et quatrième vias,
le premier et le deuxième via étant situés à l'aplomb respectivement d'une première et d'une deuxième extrémité de la bande inférieure, le troisième et le quatrième étant situés à l'aplomb respectivement d'une extrémité de la bande et de l'autre bande supérieure.

## Description

### Domaine technique

La présente description concerne de façon générale les puces électroniques, ou circuits intégrés, et en particulier une puce électronique comprenant un dispositif de détection de fissures, par exemple intégré dans un anneau de scellement, connu sous le terme de "seal-ring" en anglais.

### Technique antérieure

Dans l'industrie, la plupart des dispositifs électroniques sont fabriqués par série. Plusieurs puces électroniques sont ainsi usuellement fabriquées dans et sur un même substrat semiconducteur, par exemple une même plaque ou une tranche semiconductrice. Les puces électroniques peuvent ensuite être séparées, ou individualisées, pour pouvoir être utilisées, par exemple seules ou dans un dispositif électronique comportant d'autres composants. Cette individualisation est généralement réalisée par découpe, par exemple au moyen d'une scie.

Lors de cette individualisation, par exemple lors d'une découpe d'une plaquette semiconductrice, une fissure peut se former sur un bord d'une puce électronique et se propager dans la puce. Une telle fissure peut conduire à une défaillance des circuits électroniques de la puce électronique.

En outre, des fissures peuvent se former pendant la durée de vie de la puce, en particulier sur un bord de la puce, par exemple en raison des modifications de température de la puce électronique.

Pour protéger une puce électronique, en particulier lors de la fabrication, de l'individualisation, ou lors de l'utilisation, la puce électronique peut inclure un anneau de scellement au niveau de sa périphérie. Un objet de l'anneau de scellement est d'éviter la propagation de fissures depuis le bord jusqu'à une région de circuits électroniques de la puce. Un objet de l'anneau de scellement est aussi d'éviter la pénétration d'humidité vers les régions actives de la puce. Cependant, l'anneau de scellement n'empêche pas toujours la formation et la propagation de fissures dans la puce électronique. Ainsi, une puce électronique peut comprendre un dispositif de détection de fissures, par exemple intégré à un anneau de scellement. Le dispositif de détection de fissures peut être utilisé pour tester l'intégrité de la puce à la fabrication, par exemple après l'étape de découpe, ou pendant l'utilisation de la puce.

Il serait souhaitable de pouvoir améliorer, au moins en partie, les puces électroniques, et en particulier les dispositifs de détection de fissures intégrés dans les puces électroniques.

### Résumé de l'invention

Pour cela, un mode de réalisation prévoit une puce électronique comprenant un substrat semiconducteur et un dispositif de détection de fissures formé dans et sur le substrat semiconducteur ou sur le substrat semiconducteur, le dispositif de détection de fissures comportant, entre des première et deuxième bornes de connexion électrique du dispositif, un chemin conducteur en serpentin comportant une alternance de bandes conductrices inférieures et de bandes conductrices supérieures connectées en série, dans lequel le chemin conducteur comprend, pour chaque bande conductrice inférieure :
- un premier via conducteur sur et en contact avec la bande conductrice inférieure,
- un deuxième via conducteur sur et en contact avec la bande conductrice inférieure,
- un troisième via conducteur sous et en contact avec une bande conductrice supérieure sus-jacente,
- un quatrième via conducteur sous et en contact avec une autre bande conductrice supérieure sus-jacente,
- au moins une première piste conductrice intermédiaire connectant les premier et troisième vias conducteurs, et
- au moins une deuxième piste conductrice intermédiaire connectant les deuxième et quatrième vias conducteurs,

le premier via conducteur étant situé à l'aplomb d'une première extrémité de la bande conductrice inférieure et le deuxième via conducteur étant situé à l'aplomb d'une deuxième extrémité de la bande conductrice inférieure, le troisième via conducteur étant situé à l'aplomb d'une extrémité de la bande conductrice supérieure sus-jacente, et le quatrième via conducteur étant situé à l'aplomb d'une extrémité de l'autre bande conductrice supérieure sus-jacente, au moins 80% de la longueur du dispositif de détection de fissures étant occupée, en vue de dessus, par les bandes conductrices supérieures et au moins 80% de la longueur du dispositif de détection de fissures étant occupée, en vue de dessous, par les bandes conductrices inférieures,
et dans lequel les bandes conductrices inférieures sont en un matériau semiconducteur dopé et les bandes conductrices supérieures sont en métal.

Selon un mode de réalisation, dans le dispositif de détection de fissures:
- le premier via conducteur est situé à l'aplomb-d'une partie centrale de la bande conductrice supérieure sus-jacente ;
- le deuxième via conducteur est situé à l'aplomb d'une partie centrale de l'autre bande conductrice supérieure sus-jacente ;
- le troisième via conducteur est situé à l'aplomb d'une partie centrale de la bande conductrice inférieure ; et
- le quatrième via conducteur est situé à l'aplomb-de ladite partie centrale de la bande conductrice inférieure.

Selon un mode de réalisation, dans le dispositif de détection de fissures, le quatrième via conducteur est aligné avec le deuxième via conducteur,
le quatrième via conducteur étant situé à l'aplomb de ladite deuxième extrémité de la couche conductrice inférieure et le deuxième via conducteur étant situé à l'aplomb de ladite extrémité de l'autre bande conductrice supérieure sus-jacente.

Selon un mode de réalisation, dans le dispositif de détection, le troisième via conducteur est situé à l'aplomb d'une partie intermédiaire de la bande conductrice inférieure située au voisinage de la deuxième extrémité de la bande conductrice inférieure, ladite partie intermédiaire étant située entre la partie centrale et la deuxième extrémité de la bande conductrice inférieure.

Selon un mode de réalisation, pour chaque bande conductrice inférieure, le premier via est entièrement situé à l'aplomb des 25%, par exemple des 20%, par exemple des 10%, de la longueur de la bande les plus éloignés de la deuxième extrémité de ladite bande conductrice inférieure, et le deuxième via est entièrement situé à l'aplomb des 25%, par exemple des 20%, par exemple des 10%, de la longueur de la bande conductrice inférieure les plus éloignés de la première extrémité de ladite bande conductrice inférieure.

Selon un mode de réalisation, pour chaque bande conductrice inférieure, ladite partie centrale de la bande conductrice inférieure occupe moins de 50%, de préférence moins de 30%, et plus préférentiellement moins de 20 % de la longueur de ladite bande conductrice inférieure.

Selon un mode de réalisation, la bande conductrice inférieure est en silicium.

Selon un mode de réalisation, la puce est délimitée par un bord et le dispositif de détection de fissures est disposé entre le bord de la puce électronique et une région de circuits électroniques de la puce électronique.

Selon un mode de réalisation, le substrat semiconducteur comporte une partie dopée d'un premier type de conductivité, la bande conductrice inférieure étant entièrement formée dans la partie du substrat semiconducteur.

Selon un mode de réalisation, les bandes conductrices inférieures sont séparées deux à deux par des tranchées d'isolation.

Selon un mode de réalisation, le troisième via conducteur et le quatrième via conducteur connectés à une même bande conductrice supérieure sont associés à deux bandes conductrices inférieures consécutives, le troisième via conducteur étant associé à une bande conductrice inférieure et le quatrième via conducteur étant associé à une autre bande conductrice inférieure.

Selon un mode de réalisation, la bande conductrice inférieure est séparée de l'autre bande conductrice inférieure d'une distance comprise entre 5 nm et 10 µm.

Selon un mode de réalisation, la bande conductrice supérieure est séparée de l'autre bande conductrice supérieur d'une distance comprise entre 20 nm et 10 µm.

Selon un mode de réalisation, le dispositif de détection de fissures comprend plusieurs tronçons, chaque tronçon comportant une première et une deuxième bornes de connexion électrique du dispositif.

Un autre mode de réalisation prévoit un procédé de fabrication d'une puce électronique, comprenant une étape de formation d'un dispositif de détection de fissures dans et sur un substrat semiconductrice ou sur le substrat semiconducteur,
le dispositif de détection de fissures comportant entre des première et deuxième bornes de connexion électrique du dispositif, un chemin conducteur en serpentin comportant une alternance de bandes conductrices inférieures et de bandes conductrices supérieures connectées en série,
dans lequel le chemin conducteur comprend, pour chaque bande conductrice inférieure:
   - un premier via conducteur sur et en contact avec la bande conductrice inférieure,
un deuxième via conducteur sur et en contact avec la bande conductrice inférieure,
   - un troisième via conducteur sous et en contact avec une bande conductrice supérieure sus-jacente,
   - un quatrième via conducteur sous et en contact avec une autre bande conductrice supérieure sus-jacente,
   - au moins une première piste conductrice intermédiaire connectant les premier et troisième vias conducteurs, et
   - au moins une deuxième piste conductrice intermédiaire connectant les deuxième et quatrième vias conducteurs,
le premier via conducteur étant situé à l'aplomb d'une première extrémité de la bande conductrice inférieure, le deuxième via conducteur étant situé à l'aplomb d'une deuxième extrémité de la bande conductrice inférieure, le troisième via conducteur étant situé à l'aplomb d'une extrémité de la bande conductrice supérieure sus-jacente, et le quatrième via conducteur étant situé à l'aplomb d'une extrémité de l'autre bande conductrice supérieure sus-jacente, la longueur du dispositif de détection de fissures étant occupé, en vue de dessus, à 80 % par les bandes conductrices supérieures et, en vue de dessous à 80% par les bandes conductrices inférieures, et dans lequel les bandes conductrices inférieures sont en un matériau semiconducteur dopé et les bandes conductrices supérieures sont en métal.

Selon un mode de réalisation, le procédé comporte une étape de test de la conductivité électrique entre la première borne du dispositif de détection de fissures et la deuxième borne du dispositif de détection de fissures, de manière à détecter une éventuelle fissure coupant le chemin conducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B et la figure 1C sont des vues, partielles et schématiques, d'un exemple de puce électronique ;
la figure 2A et la figure 2B sont des vues, partielles et schématiques, d'un exemple de puce électronique selon un mode de réalisation ; et
la figure 3 est une vue en coupe, partielle et schématique, d'un exemple de puce électronique selon un autre mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, toutes les étapes de fabrication et tous les détails des puces électroniques ne sont pas décrits, les modes de réalisation décrits étant compatibles avec les procédés usuels de fabrication de puces électroniques. En particulier, les circuits électroniques des puces électroniques ne sont pas détaillés, les modes de réalisation étant compatibles avec différents circuits électroniques dans une puce électronique. En outre, toutes les étapes de fabrication et tous les détails des anneaux de scellement et des détecteurs de fissure ne sont pas décrits, les modes de réalisation décrits étant réalisables avec les procédés usuels de fabrication d'anneaux de scellement et de détecteurs de fissures.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou à 10° près, de préférence à 5 % ou à 5° près.

Dans la description qui suit, les termes "isolant" et "conducteur" signifient respectivement, sauf précision contraire, électriquement isolant et électriquement conducteur. Similairement, le terme "isoler" signifie, sauf précision contraire, isoler électriquement.

Dans la description qui suit, sauf précision contraire, lorsque l'on fait référence à une puce, il est fait référence à une puce électronique, lorsque l'on fait référence à un via, il est fait référence à un via conducteur. De plus, dans la description qui suit, le terme via ne fait pas forcément référence à un élément unitaire mais peut, par exemple, être composé de plusieurs éléments permettant d'assurer la fonction de connexion électrique.

Dans la description qui suit, lorsque l'on fait référence à un dispositif de détection de fissures, ou par raccourci à un détecteur de fissures, il est fait référence à un dispositif capable de détecter un défaut structurel qui ne se limite pas à une fissure, par exemple il peut s'agir d'une brèche ou d'une délamination. Par souci de concision, lorsque l'on fait référence à une fissure, cela peut inclure une brèche, une délamination, ou tout autre défaut de structure similaire.

Dans la description qui suit, un premier niveau de métallisation d'une structure d'interconnexion correspond généralement à un niveau de métallisation le plus proche d'un substrat semiconducteur sur lequel la structure d'interconnexion est formée et auquel la structure d'interconnexion est reliée. Un deuxième niveau de métallisation de la structure d'interconnexion correspond à un niveau de métallisation plus éloigné du substrat semiconducteur que le premier niveau de métallisation. Plus généralement, un niveau de métallisation N+1 correspond à un niveau de métallisation plus éloigné du substrat semiconducteur que le niveau de métallisation N.

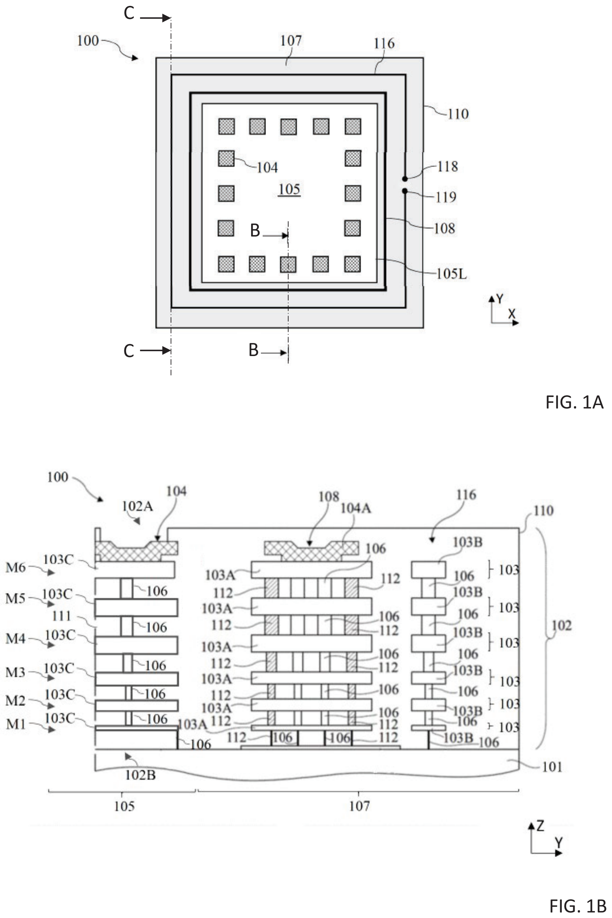

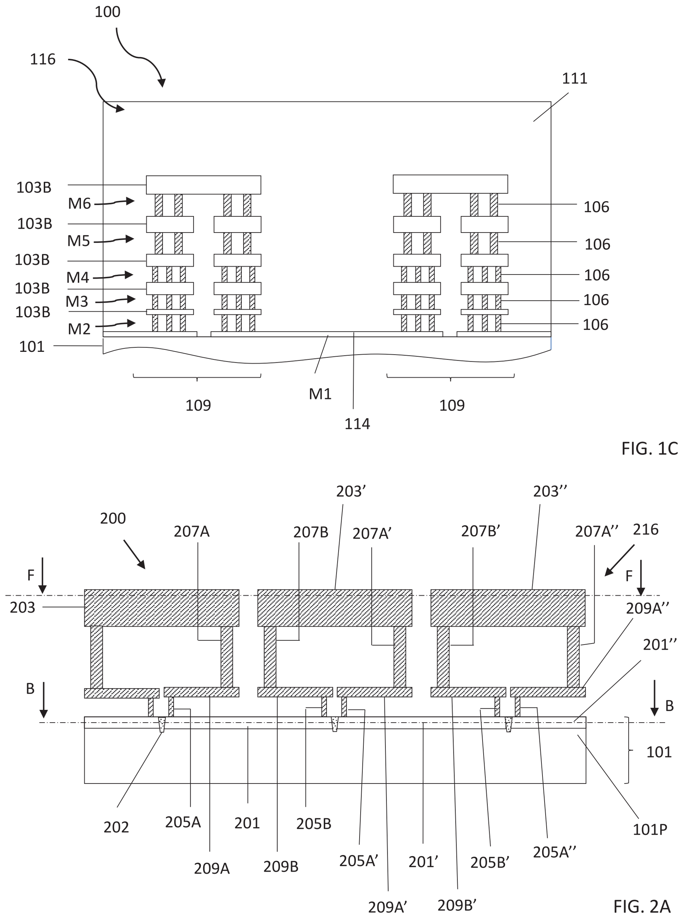

La figure 1A, la figure 1B et la figure 1C sont des vues, partielles et schématiques, d'un exemple de puce électronique 100. Plus particulièrement, la figure 1A est une vue de dessus, la figure 1B est une vue en coupe selon le plan de coupe BB de la figure 1A et la figure 1C est une vue en coupe selon le plan de coupe CC de la figure 1A.

Dans les figures 1A à 1C, la puce électronique 100 est représentée déjà individualisée. Toutefois, en pratique, la présente description peut aussi s'appliquer à une puce non individualisée, lorsque la puce fait toujours partie d'une plaquette semiconductrice comprenant, par exemple, une pluralité de puces.

La puce 100 comprend un substrat semiconducteur 101, par exemple en silicium, par exemple en silicium monocristallin. La puce 100 comprend, par exemple des circuits électroniques formés sur et dans le substrat 101. Les circuits électroniques sont, en vue de dessus, formés dans une région de circuits électroniques 105, ou région de circuits, de la puce 100. A titre d'exemple, en vue de dessus, la région de circuits 105 est située dans une partie centrale de la puce 100. La région 105 est par exemple délimitée par une circonférence 105L. A titre d'exemple, la région de circuits 105 comprend tous les circuits électroniques de la puce 100.

A titre d'exemple, la région de circuits 105 de la puce 100 est entourée latéralement par une structure de scellement 107 ou anneau de scellement (seal-ring). En d'autres termes, la structure de scellement 107 est formée en périphérie de la puce 100, c'est à dire entre la région de circuits 105 et un bord 110 de la puce 100. La structure de scellement 107 présente, par exemple, une forme annulaire en vue de dessus. A titre d'exemple, la puce 100 comprend des connexions électriques entre la région de circuit 105 et la structure de scellement 107.

Dans cet exemple, la structure de scellement 107 est formée dans une structure d'interconnexion 102 disposée au-dessus du substrat semiconducteur 101, par exemple en contact avec le substrat semiconducteur 101. Cette structure d'interconnexion 102 est également désignée par l'expression "structure d'interconnexion de fin de ligne", par raccourci structure d'interconnexion "BEOL", de l'anglais "back end of line". La structure d'interconnexion 102 peut comporter, par exemple dans une partie centrale de la puce, des éléments métalliques d'interconnexion des circuits électroniques de la puce.

La structure de scellement 107 est disposée dans la structure d'interconnexion 102, au niveau de la périphérie de la puce 100.

La structure d'interconnexion 102 comprend par exemple une pluralité de niveaux de métallisations. En figures 1B et 1C, six niveaux de métallisations M1, M2, M3, M4, M5, M6 ont été représentés. En pratique, le nombre de niveaux de métallisations peut être différent de six.

A titre d'exemple, au sein de la région de circuits 105, les niveaux de métallisations comportent chacun au moins une portion 103C d'une couche conductrice 103. A titre d'exemple, chaque portion 103C correspond à un élément conducteur sous forme d'une piste conductrice, ou ligne conductrice.

La couche conductrice 103 est par exemple une couche métallique, par exemple en cuivre.

Les portions 103C des différents niveaux de métallisations sont par exemple connectés électriquement les uns aux autres par des vias conducteurs 106. A titre d'exemple, le niveau de métallisations supérieur, par exemple le niveau de métallisations M6 est connecté, par sa face supérieure à un plot de connexion 104. A titre d'exemple, les plots 104 sont disposés au niveau d'une face supérieure 102A de la structure d'interconnexion 102, une face inférieure 102B de la structure d'interconnexion, à l'opposé de la face supérieure 102A, étant en contact avec le substrat semiconducteur 101.

Les plots 104 sont par exemple répartis de manière sensiblement annulaire, ici un anneau de forme carrée, dans la région de circuits 105 de la puce 100. Les modes de réalisation décrits ne se limitent toutefois pas à cet agencement particulier.

Les plots 104 sont configurés pour être en contact avec des éléments conducteurs situés à l'extérieur de la puce 100, de façon à connecter électriquement la puce à un système externe.

Les niveaux de métallisations de la structure d'interconnexion 102 sont, par exemple, entourés par des couches isolantes, qui sont toutes désignées par une même et unique référence 111.

Une fonction visée de la structure de scellement 107 est d'éviter la propagation de fissures depuis le bord 110 de la puce 100 jusqu'à la région de circuits 105 de la puce 100.

Une autre fonction visée de la structure de scellement 107 peut être de bloquer la propagation de l'humidité depuis l'extérieur de la puce 100, donc depuis le bord 110 de la puce 100, jusqu'aux circuits électroniques de la région de circuits 105 de la puce 100.

Pour remplir une ou plusieurs de ces fonctions, la structure de scellement 107 peut inclure un ou plusieurs éléments de scellement 108, chaque élément de scellement 108 présentant une forme annulaire en vue de dessus.

Chaque élément de scellement 108 s'étend en hauteur depuis le substrat semiconducteur 101 à travers tout ou partie des niveaux de métallisations M1-M6 de la structure d'interconnexion 102, par exemple à travers un ou plusieurs niveaux de métallisations inférieurs de la structure d'interconnexion 102. Pour la protection contre l'humidité, il est cependant préférable que l'élément de scellement 108 s'étende jusqu'au niveau de métallisations supérieur, ici le niveau M6.

L'élément de scellement 108 représenté forme une boucle fermée autour de la région de circuits 105 de la puce 100, ou, en d'autres termes, l'élément de scellement 108 entoure complétement la région de circuits 105 de la puce 100.

Dans l'exemple de réalisation représenté en figure 1B, l'élément de scellement 108 forme un mur annulaire comprenant d'autres portions 103A des couches conductrices 103 de la structure d'interconnexion 102. Plus précisément, l'élément de scellement 108 comprend une portion 103A de la couche conductrice 103 de chaque niveau de métallisation M1-M6 de la structure d'interconnexion 102. Chaque portion 103A de la couche conductrice 103 forme une plaque conductrice annulaire à chaque niveau de métallisations. Les plaques conductrices annulaires 103A successives de l'élément de scellement 108 sont reliées entre elles par une ou plusieurs bandes conductrices annulaires 112 qui s'étendent en continu entre deux plaques conductrices annulaires 103A successives.

Comme représenté en figure 1B, les plaques conductrices annulaires 103A successives de l'élément de scellement 108 peuvent en outre être reliées entre elles par des vias conducteurs 106 de la structure d'interconnexion 102, permettant par exemple d'augmenter la résistance mécanique de l'élément de scellement 108 vis-à-vis d'une propagation de fissure.

L'élément de scellement 108 peut former un mur de protection contre la propagation de l'humidité vers la région de circuits 105 de la puce 100.

Comme représenté en figure 1B, l'l'élément| de scellement 108 peut comprendre un plot factice 104A, qui est par exemple formé en même temps que les plots 104. Le plot factice 104A repose sur la plaque conductrice annulaire 103A au niveau de métallisations supérieur M6 de la structure d'interconnexion 102. Le plot factice 104A peut être disposé de manière sensiblement annulaire, ici il forme un anneau de forme carrée. Il peut s'agir de plusieurs plots factices.

Afin de détecter des fissures dans la puce 100, la structure de scellement 107 peut inclure un dispositif de détection de fissures 116, ou détecteur de fissures. Dans cet exemple, le détecteur de fissures 116 est formé sur le substrat semiconducteur, dans la structure d'interconnexion 102. Comme représenté en figures 1A, 1B et 1C, le dispositif de détection de fissures 116 peut être disposé dans une région comprise entre le bord 110 de la puce 100 et l'élément de scellement 108. Ainsi, si une fissure apparaît au niveau du bord 110 de la puce 100 et se propage vers la région de circuits 105, la fissure peut être détectée par le dispositif de détection de fissures 116 avant l'élément de scellement 108. D'autres configurations peuvent toutefois être envisagées.

A titre d'exemple, le dispositif de détection de fissure 116 est placé entre deux éléments de scellement 108 distincts. Les dispositifs de détection de fissures 116 et les éléments de scellement 108 ne sont pas limités à ceux décrits. De plus, le nombre de dispositifs de détection de fissures 116 et d'éléments de scellement 108 n'est pas limité. On peut ainsi prévoir plusieurs exemplaires de dispositifs de détection de fissures 116 et d'éléments de scellement 108 dans la structure de scellement 107.

Le dispositif de détection de fissures 116 correspond à une structure conductrice qui forme un trajet conducteur, de préférence une boucle ouverte, entre une première borne, ou nœud 118, par exemple une première extrémité du dispositif de détection 116, et une deuxième borne 119, par exemple une deuxième extrémité du dispositif de détection 116. En testant la conductivité électrique entre la première borne 118 du dispositif de détection 116, et la deuxième borne 119 du dispositif de détection 116, des fissures peuvent être détectées par le dispositif de détection 116. En variante, le dispositif de détection de fissures 116 comprend plusieurs tronçons non reliés électriquement entre eux, chaque tronçon comportant deux bornes.

Dans l'exemple de réalisation représenté en figures 1B et 1C, le dispositif de détection de fissures 116 comprend une pluralité d'empilements métalliques 109 comprenant chacun d'autres portions 103B des couches conductrices 103 reliés par des vias conducteurs 106 de la structure d'interconnexion 102. Les empilements métalliques 109 sont par exemple organisés le long du dispositif de détection de fissures 116. Plus précisément, chaque empilement métallique 109 s'étend en hauteur dans la direction Z perpendiculaire au plan XY du substrat semiconducteur 101 à travers tout ou partie des niveaux de métallisations M1-M6 de la structure d'interconnexion 102, dans l'exemple représenté jusqu'au niveau de métallisations supérieur M6. A titre d'exemple, les empilements métalliques 109 comportent chacun deux parties verticales se faisant face, par exemple identiques, reliées entre elles uniquement par le niveau de métallisations supérieur, par exemple le niveau M6. Les empilements métalliques 109 ont ainsi chacun la forme d'un pont dont les pieds ou piliers sont les deux parties verticales et dont le tablier correspond à la couche conductrice 103 du niveau de métallisations M6.

Dans l'exemple représenté, les pieds voisins de deux empilements métalliques 109 voisins sont reliés uniquement par une couche métallique 114 formée dans le niveau de métallisation M1. Ainsi, le dispositif de détection de fissures 116 a, en vue en coupe, selon le plan de coupe de la figure 1C, une forme de serpentin en créneau dont les parties verticales correspondent aux piliers verticaux des empilements métalliques 109 et dont les parties horizontales sont, en alternance, des portions de la couche inférieure 114 du niveau de métallisations inférieur M1 et des portions de la couche 103 du niveau de métallisations supérieur M6.

Il a été constaté par les inventeurs que des fissures pouvaient se propager dans la structure de scellement 107, voire traverser la structure de scellement, sans être détectées par le détecteur de fissure 116.

En particulier, certaines fissures verticales sont susceptibles de se propager à travers le dispositif de détection de fissures 116, éventuellement en déformant la couche métallique inférieure 114 mais sans la rompre en raison de la nature ductile de la couche 114. Ces fissures n'entrainent ainsi pas de rupture du chemin conducteur entre les bornes 118 et 119 du dispositif de détection 116, et ne sont par conséquent pas détectées.

De plus, des fissures horizontales se propageant sous la structure de scellement 107, et plus particulièrement entre la couche 114 et le substrat 101 peuvent également ne pas être détectées.

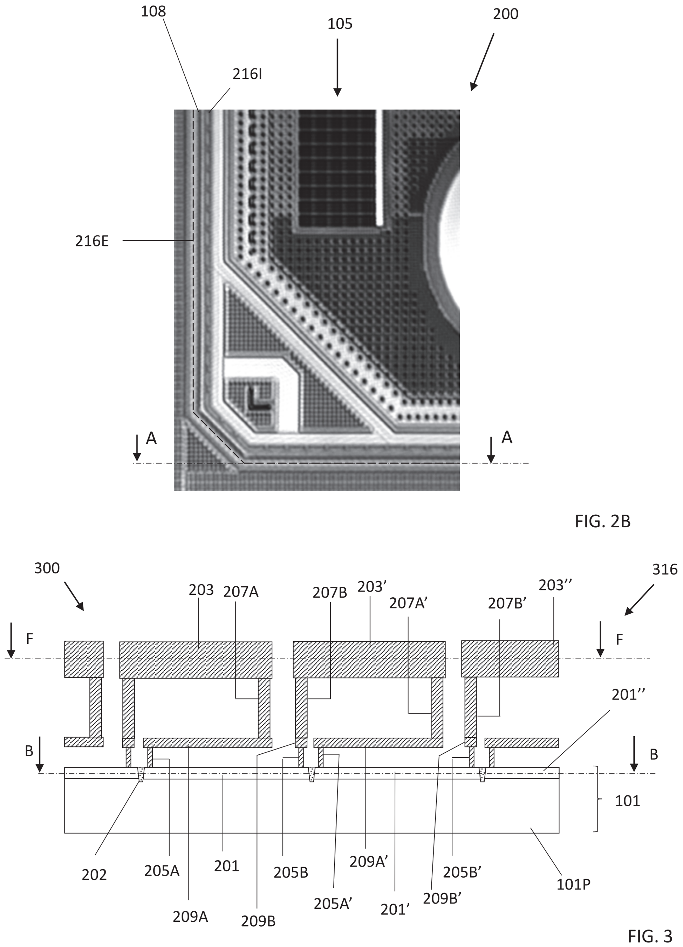

La figure 2A et la figure 2B sont des vues, partielles et schématiques, d'un exemple de puce électronique 200 selon un mode de réalisation, la figure 2B étant une photo illustrative en vue de dessus et la figure 2A étant une vue en coupe schématique selon le plan de coupe AA de la figure 2B.

La puce électronique 200 est par exemple similaire à la puce électronique 100 illustrée en figures 1A à 1C à la différence près que la puce 200 comprend un dispositif de détection de fissures 216 différent du dispositif de détection de fissures 116.

Comme le dispositif 116 des figures 1A à 1C, le dispositif 216 comprend un chemin électriquement conducteur, par exemple en forme de boucle ouverte entourant latéralement les parties actives de la puce, entre deux bornes de connexion (non visibles sur les figures 2A et 2B) correspondant par exemple aux bornes 118 et 119 du dispositif 116. En vue de dessus, l'agencement du dispositif de détection de fissures 216 est par exemple similaire à celui du dispositif 116. Similairement à ce qui a été décrit en relation avec les figures 1A à 1C, le dispositif de détection de fissures 216 peut comprendre plusieurs tronçons reliés par des bornes supplémentaires. Ainsi, le nombre de borne au sein du dispositif de détection de fissures 216 n'est pas limité à deux.

Le dispositif de détection 216 des figures 2A et 2B comprend un chemin conducteur en serpentin comportant une alternance de bandes conductrices inférieures 201 et de bandes conductrices supérieures 203 connectées en série entre les bornes de connexion du dispositif.

Selon un aspect des modes de réalisation décrits, les bandes conductrices inférieures sont en un matériau semiconducteur dopé, par exemple en silicium dopé.

Dans un mode de réalisation, chaque bande conductrice inférieure 201 est formée par une région dopée du substrat 101 de sorte que les bandes 201 affleurent, par leurs faces supérieures, la face supérieure du substrat 101. A titre d'exemple, les bandes 201 s'étendent dans le substrat 101 sur une profondeur comprise dans une plage allant de quelques nm, par exemple 10 nm, à 100 nm.

En variante, les bandes conductrices 201 sont enterrées dans le substrat 101. Dans cette variante, chaque bande conductrice 201 est prolongée, jusqu'à la face supérieure du substrat 101, au moins sur ses deux extrémités, par exemple sur ses deux extrémités uniquement. A titre d'exemple, la prolongation des bandes 201 est réalisé par une autre couche conductrice. Ainsi, la couche conductrice 201 ne débouche pas sur la face supérieure du substrat 101 et seules les prolongations en l'autre couche conductrice débouchent sur la face supérieure du substrat 101.

A titre d'exemple, le substrat 101 comprend une partie 101P dopée d'un premier type de conductivité, par exemple du type P.

A titre d'exemple, la première partie 101P du substrat 101 s'étend plus profondément que les bandes conductrices 201. C'est-à-dire que les bandes conductrices 201 sont entièrement formées dans la partie supérieure 101P du substrat 101.

Les bandes conductrices inférieures 201 sont par exemple dopées d'un deuxième type de conductivité opposé à celui de la région 101P. A titre d'exemple, les bandes conductrices inférieures 201 sont dopées de type N.

Cette configuration permet d'assurer l'isolation électrique des bandes 201 les unes par rapport aux autres et par rapport au substrat.

A titre d'exemple, les bandes conductrices 201 sont en un matériau semiconducteur. A titre d'exemple, les bandes conductrices 201 sont en un matériau non ductile (c'est-à-dire un matériau qui ne peut pas être allongé, étiré ou étendu sans se rompre), par exemple moins ductile que les métaux de la structure d'interconnexion.

En variante, les bandes conductrices inférieures 201 sont formées sur le substrat 101, par exemple dans un niveau de formation de grilles conductrices en silicium polycristallin dopé. Plus généralement, les bandes conductrices inférieures 201 peuvent être formées dans tout autre niveau de formation présent sous le niveau de métallisations M1.

Les bandes conductrices 201 sont par exemple alignées selon un axe longitudinal du chemin conducteur du détecteur de fissures, et non connectées directement entre elles. A titre d'exemple, les bandes conductrices 201 sont séparées deux à deux par des tranchées isolantes 202 en un matériau isolant, par exemple en oxyde de silicium. A titre d'exemple, les tranchées 202 s'étendent plus profondément que les bandes conductrices 201. Les tranchées 202 sont par exemple formées en même temps que d'autres tranchées isolantes formées par exemple autour de transistors dans la région de circuits 105. Les tranchées 202 sont par exemple des tranchées de type STI (de l'anglais « Shallow Trench Isolation » - tranchées d'isolation peu profondes). En variante, les tranchées 202 sont par exemple des tranchées de type DTI (de l'anglais « Deep Trench Isolation » - tranchées d'isolation profondes).

A titre d'exemple, la distance entre deux bandes 201 voisines est supérieure à 5 nm. La distance entre deux bandes 201 voisines est par exemple inférieure à 10 µm. La distance entre deux bandes 201 voisines est par exemple inférieure à 5 µm. En effet, la fiabilité du dispositif de détection de fissures 216 repose entres autres sur la distance entre deux bandes voisines 201, cette distance doit donc être la plus faible possible afin d'augmenter la fiabilité du dispositif.

Les bandes conductrices supérieures 203 sont par exemple alignée selon un axe longitudinal du chemin conducteur du détecteur de fissures, parallèlement aux bandes conductrices inférieures 201, et non connectées directement entre elles. Elles sont par exemple espacées deux à deux par une mince région en un matériau diélectrique de la structure d'interconnexion.

A titre d'exemple, la distance entre deux bandes 203 voisines est supérieure à 20 nm. La distance entre deux bandes 203 voisines est par exemple inférieure à 10 µm. La distance entre deux bandes 203 voisines est par exemple inférieure à 5 µm. En effet, similairement à ce qui a été décrit pour la distance entre les bandes 201, la fiabilité du dispositif de détection de fissures 216 repose entres autres sur la distance entre deux bandes voisines 203, cette distance doit donc être la plus faible possible afin d'augmenter la fiabilité du dispositif.

A titre d'exemple, les bandes conductrices inférieures 201 sont majoritairement recouvertes par les bandes conductrices supérieures 203. C'est-à-dire qu'une majorité de la surface des bandes conductrices inférieures 201 est recouverte par les bandes conductrices supérieures 203.

A titre d'exemple, les bandes inférieures 201 sont formées sous et en vis-à-vis des bandes supérieures 203. Les bandes inférieures 201 sont toutefois décalées par rapport aux bandes supérieures 203 de sorte qu'une partie centrale d'une bande supérieure 203 se retrouve alignée verticalement avec une région de séparation entre deux bandes inférieures 201 consécutives et qu'une partie centrale d'une bande inférieure 201 se retrouve alignée verticalement avec une région de séparation entre deux bandes supérieures 203 consécutives. Les bandes conductrices inférieures 201 et les bandes conductrices supérieures 203 ont par exemple sensiblement la même longueur. A titre de variante, les bandes conductrices inférieures 201 et les bandes conductrices supérieures 203 ont des longueurs différentes.

Chacune des bandes conductrices inférieures 201 est connectée à un premier via conducteur 205A, chacun des premiers vias 205A étant formé sur et en contact avec la bande conductrice 201 à laquelle il est connecté.

Chaque premier via conducteur 205A est situé à l'aplomb d'une première extrémité de la bande conductrice inférieure 201 à laquelle il est connecté. A titre d'exemple, chaque premier via 205A est ainsi entièrement situé à l'aplomb des 25%, par exemple des 20%, par exemple des 10%, de la longueur de la bande conductrice inférieure 201 les plus éloignés d'une deuxième extrémité de la bande conductrice inférieure 201, opposée à la première extrémité. En outre, chaque premier via 205A est, dans le mode de réalisation illustré en figure 2A, situé à l'aplomb d'une partie centrale de la bande conductrice supérieure 203 sus-jacente.

Chacune des bandes conductrices inférieures 201 est en outre connectée à un deuxième via conducteur 205B, chacun des deuxièmes vias 205B étant formé sur et en contact avec la bande conductrice 201 à laquelle il est connecté.

Chaque deuxième via conducteur 205B est situé à l'aplomb de la deuxième extrémité de la bande conductrice inférieure 201 à laquelle il est connecté. A titre d'exemple, chaque deuxième via 205B est ainsi entièrement situé à l'aplomb des 25%, par exemple des 20%, par exemple des 10%, de la longueur de la bande conductrice inférieure 201 les plus éloignés de la première extrémité de ladite bande conductrice inférieure 201. En outre, chaque deuxième via 205B est, dans le mode de réalisation illustré en figure 2A, situé à l'aplomb d'une partie centrale de la bande conductrice supérieure 203 sus-jacente.

A titre d'exemple, les vias 205A et 205B associés à la même bande conductrice inférieure 201 sont recouverts par deux bandes conductrices supérieures 203 consécutives. Dans l'exemple de la figure 2A, le via 205A est recouvert par la bande supérieure 203 et est formé en vis-à-vis d'une partie centrale de la bande supérieure 203. Dans l'exemple de la figure 2A, le via 205B est recouvert par la bande supérieure 203' et est formée vis-à-vis d'une partie centrale de la bande supérieure 203'.

A titre d'exemple, la partie centrale d'une bande conductrice supérieure 203, à l'aplomb de laquelle sont situés un premier 205A et un deuxième 205B via, occupe moins de 50%, de préférence moins de 30%, et plus préférentiellement moins de 20 % de la longueur de ladite bande conductrice supérieure 203.

Le dispositif de détection des fissures 216 comporte en outre, en vis-à-vis de chaque bande conductrice 201, un troisième via conducteur 207A. Le troisième via 207A est formé sous et en contact avec une bande conductrice supérieure 203 sus-jacente.

Chaque troisième via conducteur 207A est situé à l'aplomb d'une première extrémité de la bande conductrice supérieure 203 à laquelle il est connecté. A titre d'exemple, chaque troisième via 207A est ainsi entièrement situé à l'aplomb des 25%, par exemple des 20%, par exemple des 10%, de la longueur de la bande conductrice supérieure les plus éloignés d'une deuxième extrémité de ladite bande conductrice supérieure 203, opposée à la première extrémité. En outre, chaque troisième via 207A est, dans le mode de réalisation illustré en figure 2A, situé à l'aplomb d'une partie centrale de la bande conductrice inférieure 201 sous-jacente.

Le dispositif de détection des fissures 216 comporte en outre, en vis-à-vis de chaque bande conductrice 201, un quatrième via conducteur 207B. Le quatrième via 207B est formé sous et en contact avec une bande conductrice supérieure 203 sus-jacente.

Les vias 207A et 207B sont formés sous deux bandes conductrices supérieures 203 consécutives. Dans l'exemple de la figure 2A, le via 207A est formé sous la bande supérieure 203. Dans l'exemple de la figure 2A, le via 207B est formé sous la bande supérieure 203'.

Chaque quatrième via conducteur 207B est situé à l'aplomb d'une première extrémité de la bande conductrice supérieure 203' sus-jacente. A titre d'exemple, chaque quatrième via 207B est ainsi entièrement situé à l'aplomb des 25%, par exemple des 20%, par exemple des 10%, de la longueur de la bande conductrice supérieure les plus éloignés d'une deuxième extrémité de ladite bande conductrice supérieure 203, opposée à la première extrémité. En outre, chaque quatrième via 207B est, dans le mode de réalisation illustré en figure 2A, situé à l'aplomb d'une partie centrale de la bande conductrice inférieure 201 sous-jacente.

A titre d'exemple, la partie centrale de la bande conductrice inférieure 201, à l'aplomb de laquelle sont situés les troisième 207A et quatrième 207B vias, occupe moins de 50%, de préférence moins de 30%, et plus préférentiellement moins de 20 % de la longueur de ladite bande conductrice inférieure 201.

A titre d'exemple, chaque bande conductrice supérieure, par exemple la bande 203' en figure 2A, est connectée :
- à un quatrième via conducteur, par exemple le via 207B en figure 2A, et
- à un troisième via conducteur, par exemple le via 207A' en figure 2A,
le troisième via et le quatrième via conducteur étant formés en vis-à-vis de deux bandes inférieures consécutives.

Le dispositif de détection des fissures 216 comporte en outre, à l'aplomb de chaque bande inférieure 201, au moins une première piste conductrice intermédiaire 209A connectant les premier 205A et troisième 207A vias conducteurs, et au moins une deuxième piste conductrice intermédiaire 209B connectant les deuxième 205B et quatrième 207B vias conducteurs.

A titre d'exemple, le premier via conducteur 205A est connecté à la première piste conductrice intermédiaire 209A à l'aplomb d'une première extrémité de la première piste 209A. A titre d'exemple, le troisième via 207A est connecté à la première piste conductrice intermédiaire 209A à l'aplomb d'une deuxième extrémité de la première piste 209A, opposée à la première extrémité de la première piste 209A.

Similairement, à titre d'exemple, le deuxième via conducteur 205B est connecté à la deuxième piste conductrice intermédiaire 209B à l'aplomb d'une première extrémité de la deuxième piste 209B. A titre d'exemple, le quatrième via 207B est connecté à la deuxième piste conductrice intermédiaire 209B à l'aplomb d'une deuxième extrémité de la deuxième piste 209B, opposée à la première extrémité de la deuxième piste 209B.

A titre d'exemple, le chemin conducteur en serpentin du dispositif de détection de fissures 216 comprend la succession de bandes conductrices supérieures 203, 203', 203'', de troisièmes vias conducteurs 207A, 207A', 207A'', de premières pistes conductrices intermédiaires 209A, 209A', 209A", de premiers vias conducteurs 205A, 205A', 205A'', de bandes conductrices inférieures 201, 201', 201'', de deuxièmes vias conducteurs 205B, 205B', de deuxièmes pistes conductrices intermédiaires 209B, 209B' et de quatrièmes vias conducteurs 207B, 207B'.

Les bandes conductrices supérieures 203 sont en métal ou en un alliage métallique. A titre d'exemple, les bandes 203 sont en cuivre, en aluminium ou en un alliage de cuivre et d'aluminium.

Les troisièmes 207A et quatrièmes 207B vias conducteurs sont par exemple en métal, par exemple en cuivre, en aluminium ou en un mélange de cuivre et d'aluminium.

Les premiers 205A et deuxièmes 205B vias conducteurs sont par exemple en un matériau métallique, par exemple en tungstène ou en tantale, ou en un mélange de cuivre et de tantale.

A titre d'exemple, bien que cela ne soit pas représenté en figure 2A, les vias conducteurs 207A et 207B peuvent chacun correspondre à un empilement conducteur formé d'autres pistes intermédiaires conductrices et de vias reliant les pistes intermédiaires.

Dans cet exemple, les vias conducteurs formés entre des pistes conductrices intermédiaires sont formés à l'aplomb d'une des extrémités de pistes conductrices sus- et sous-jacentes ou en vis-à-vis d'une partie centrale de ces pistes conductrices intermédiaires.

A titre d'exemple, les vias reliant deux pistes conductrices intermédiaires sont alignés verticalement.

En variante, les vias reliant deux pistes conductrices intermédiaires ne sont pas alignes verticalement.

Comme cela été représenté en figure 2B, la structure de scellement 107 peut comprendre un dispositif de détection de fissures interne 216I disposé dans la structure d'interconnexion 102 autour de, ou sur les bords de, la région de circuits 105 et être entourée par l'élément de scellement 108, ou l'élément de scellement interne. Le dispositif de détection de fissures interne 216I permet de détecter des fissures qui se sont propagées depuis le bord 110 de la puce 100 à travers le (ou les) élément(x) de scellement et peuvent atteindre la région de circuits 105.

Comme cela été représenté en figure 2B, la structure de scellement 107 peut en outre comprendre un dispositif de détection de fissures externe 216E disposé dans la structure d'interconnexion 102 autour de l'élément de scellement 108.

A titre de variante, l'un ou l'autre des dispositifs de détection de fissures 216I et 216E peut être omis. De plus, l'élément de scellement 108 peut être omis.

La figure 3 est une vue en coupe, partielle et schématique, d'un exemple de puce électronique 300 selon un autre mode de réalisation.

La puce électronique 300 comprend par exemple les mêmes éléments que la puce 200 illustrée en figures 2A et 2B. La puce 300 comprend en outre un dispositif de détection de fissures 316 similaire au dispositif de détection de fissures 216 à la différence près que la structure, formée par les vias 205A, 205B, 207A et 207B, la bande inférieure 201, les bandes supérieures 203 et 203' et les pistes 209A et 209', n'est pas symétrique.

Dans ce mode de réalisation, les vias 205B et 207B sont alignés.

Dans ce mode de réalisation, chaque via 207B est situé à l'aplomb d'un via 205B. Dans ce mode de réalisation, chacun des vias 205B et 207B est situé à l'aplomb de la deuxième extrémité de la bande conductrice inférieure 201 sous-jacente. En outre, dans ce mode de réalisation, chacun des vias 205B et 207B est situé à l'aplomb de la première extrémité de la bande conductrice supérieure 203' sus-jacente.

A titre d'exemple, le troisième via conducteur 207A est situé à l'aplomb d'une partie intermédiaire située au voisinage de la deuxième extrémité de la bande conductrice inférieure 201 sous-jacente, la partie intermédiaire étant située entre la deuxième extrémité et la partie centrale de la bande conductrice inférieure 201.

A titre d'exemple, le premier via conducteur 205A est situé à l'aplomb d'une partie intermédiaire située au voisinage d'une deuxième extrémité de la bande conductrice supérieure 203 sus-jacente, la partie intermédiaire étant située entre la deuxième extrémité et la partie centrale de la bande conductrice supérieure 203.

Plus généralement, les pistes conductrices 201 et 203 peuvent avoir d'autres agencements que ceux décrits en relation avec les figures 2A et 3. Selon un aspect des modes de réalisations décrits, au moins 80%, de préférence au moins 90%, de la longueur du dispositif de détection de fissures est occupée, en vue de dessus ou dans un plan de coupe horizontal FF dans le niveau de métallisation supérieur des bandes conductrices 203, 203', 203'', par les bandes conductrices supérieures 203, 203', 203''.

Similairement, selon un aspect des modes de réalisations décrits, au moins 80%, de préférence a moins 90%, de la longueur du dispositif de détection de fissures est occupée, en vue de dessous, ou dans un plan de coupe horizontal BB dans le niveau des bandes conductrices inférieures 201, 201', 201'', par les bandes conductrices inférieures 201, 201', 201''.

Un avantage des modes de réalisation décrits est lié à la forme du serpentin constituant le chemin conducteur du dispositif de détection de fissures 216, comprenant une succession de boucles tête-bêche imbriquées, offrant une bonne couverture de la surface de détection à la fois par les bandes conductrices supérieures 203 et par les bandes conductrices inférieures 201. Ceci permet d'augmenter la sensibilité de détection.

La faible distance séparant les bandes conductrices inférieures 201 consécutives, et la faible distance séparant les bandes conductrices supérieures 203 consécutives permet également d'augmenter la sensibilité de détection.

Un autre avantage des modes de réalisation décrits est que la présence des pistes conductrices intermédiaires permet de détecter les délaminations intermétalliques.

Un autre avantage des modes de réalisation décrits est lié à l'utilisation d'un matériau semiconducteur, non ductile (c'est-à-dire un matériau qui ne peut pas être allongé, étiré ou étendu sans se rompre) ou moins ductile que les métaux de la structure d'interconnexion, pour former les bandes conductrices inférieures 201. Ceci permet une meilleure détection des fissures verticales ou des délaminations entre les niveaux de métallisations et le substrat semiconducteur.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que cela n'ait pas été représentée en figures 2A et 2B, on peut prévoit que chaque via conducteur 205A, 205B, 207A et 207B corresponde à un ensemble de plusieurs vias conducteurs regroupés, c'est-à-dire des vias conducteurs formés à proximité les uns des autres.

En tout état de cause, les surfaces de contact entre les vias conducteurs 205A, 205B, 207A, 207B et les bandes conductrices 201, 203 sont de préférence entièrement situées dans les 25%, par exemple dans les 20%, par exemple dans les 10%, de la longueur des bandes conductrices les plus proches des extrémités des bandes conductrices. Autrement dit, de préférence, aucun via de connexion électrique n'est en contact avec la face supérieure des bandes conductrice 201 dans une partie centrale s'étendant sur 60%, de préférence 80% de la longueur de chaque bande, et aucun via de connexion électrique n'est en contact avec la face inférieure des bandes conductrice 203 dans une partie centrale s'étendant sur 60%, de préférence 80% de la longueur de chaque bande. Dit encore autrement, les surfaces de connexion des bandes conductrices 201 et 203 sont de préférence entièrement situées dans les 25%, par exemple dans les 20%, par exemple dans les 10%, de la longueur des bandes conductrices les plus proches des extrémités des bandes conductrices. Plus particulièrement, les surfaces de connexion de chaque bande conductrice inférieure 201 aux deux bandes conductrices supérieures 203 sus-jacentes, c'est-à-dire les surfaces par laquelle la bande conductrice inférieure 201 est connectée respectivement aux deux bandes conductrices supérieures 203 sus-jacentes, sont de préférence entièrement situées respectivement dans les 25%, par exemple dans les 20%, par exemple dans les 10%, de la longueur de la bande conductrice inférieure 201 les plus proches des deux extrémités de ladite bande. Similairement, les surfaces de connexion de chaque bande conductrice supérieure 203 aux deux bandes conductrices inférieures 201 sous-jacentes, c'est-à-dire les surfaces par laquelle la bande conductrice supérieure 203 est connectée respectivement aux bandes conductrices inférieures 201 sous-jacentes, sont de préférence entièrement situées respectivement dans les 25%, par exemple dans les 20%, par exemple dans les 10%, de la longueur de la bande conductrice supérieure 203 les plus proches des deux extrémités de ladite bande.

Enfin, la mise en oeuvre pratique des modes de réalisation et variantes décrits est à la portée de la personne du métier à partir des indications fonctionnelles données ci-dessus.

## Revendications

1. Dispositif de détection de fissures (216 ; 316) comportant une alternance de bandes conductrices inférieures (201, 201', 201'') et de bandes conductrices supérieures (203, 203', 203'') connectées en série, dans lequel les surfaces de connexion des bandes conductrices les unes aux autres sont entièrement situées dans les 25% de la longueur des bandes conductrices les plus proches des extrémités des bandes.

2. Dispositif (216 ; 316) selon la revendication 1, dans lequel les surfaces de connexion des bandes conductrices les unes aux autres sont entièrement situées dans les 20%, par exemple dans les 10% de la longueur des bandes conductrices les plus proches des extrémités des bandes.

3. Dispositif (216 ; 316) selon la revendication 1 ou 2, dans lequel au moins 80% de la longueur du dispositif est occupée, en vue de dessus, par les bandes conductrices supérieures (203, 203', 203'') et au moins 80% de la longueur du dispositif est occupée, en vue de dessous, par les bandes conductrices inférieures (201, 201', 201").

4. Dispositif (216 ; 316) selon l'une quelconque des revendications 1 à 3, dans lequel les bandes conductrices inférieures (201) sont en un matériau semiconducteur dopé et les bandes conductrices supérieures (203, 203', 203'') sont en métal.

5. Dispositif (216 ; 316) selon l'une quelconque des revendications 1 à 4, dans lequel les bandes conductrices inférieures (201, 201', 201") et supérieures (203, 203', 203'') définissent un chemin conducteur entre des première (118) et deuxième (119) bornes de connexion électrique du dispositif.

6. Dispositif (216 ; 316) selon la revendication 4, dans lequel le chemin conducteur comprend, pour chaque bande conductrice inférieure (201):
- un premier via conducteur (205A) sur et en contact avec la bande conductrice inférieure (201),
- un deuxième via conducteur (205B) sur et en contact avec la bande conductrice inférieure (201),
- un troisième via conducteur (207A) sous et en contact avec une bande conductrice supérieure (203) sus-jacente,
- un quatrième via conducteur (207B) sous et en contact avec une autre bande conductrice supérieure (203') sus-jacente,
- au moins une première piste conductrice intermédiaire (209A) connectant les premier (205A) et troisième (207A) vias conducteurs, et
- au moins une deuxième piste conductrice intermédiaire (209B) connectant les deuxième (205B) et quatrième (207B) vias conducteurs,
le premier via conducteur (205A) étant situé à l'aplomb d'une première extrémité de la bande conductrice inférieure (201) et le deuxième via conducteur (205B) étant situé à l'aplomb d'une deuxième extrémité de la bande conductrice inférieure (201) , le troisième via conducteur (207A) étant situé à l'aplomb d'une extrémité de la bande conductrice supérieure (203) sus-jacente, et le quatrième via conducteur (207B) étant situé à l'aplomb d'une extrémité de l'autre bande conductrice supérieure (203') sus-jacente.

7. Dispositif (216) selon la revendication 6, dans lequel:
- le premier via conducteur (205A) est situé à l'aplomb d'une partie centrale de la bande conductrice supérieure (203) sus-jacente ;
- le deuxième via conducteur (205B) est situé à l'aplomb d'une partie centrale de l'autre bande conductrice supérieure (203') sus-jacente ;
- le troisième via conducteur (207A) est situé à l'aplomb d'une partie centrale de la bande conductrice inférieure (201) ; et
- le quatrième via conducteur (207B) est situé à l'aplomb de ladite partie centrale de la bande conductrice inférieure (201).

8. Dispositif (216) selon la revendication 7, dans laquelle, pour chaque bande conductrice inférieure (201), ladite partie centrale de la bande conductrice inférieure (201) occupe moins de 50%, de préférence moins de 30%, et plus préférentiellement moins de 20 % de la longueur de ladite bande conductrice inférieure (201).

9. Dispositif (316) selon la revendication 6, dans lequel le quatrième via conducteur (207B) est aligné avec le deuxième via conducteur (205B), le quatrième via conducteur (207B) étant situé à l'aplomb de ladite deuxième extrémité de la couche conductrice inférieure (201) et le deuxième via conducteur (205B) étant situé à l'aplomb de ladite extrémité de l'autre bande conductrice supérieure (203') sus-jacente.

10. Dispositif (316) selon la revendication 9, dans lequel le troisième via conducteur (207A) est situé à l'aplomb d'une partie intermédiaire de la bande conductrice inférieure (201) située au voisinage de la deuxième extrémité de la bande conductrice inférieure (201), ladite partie intermédiaire étant située entre une partie centrale et la deuxième extrémité de la bande conductrice inférieure (201).

11. Dispositif (216 ; 316) selon l'une quelconque des revendications 6 à 9, dans lequel, pour chaque bande conductrice inférieure (201), le premier via (205A) est entièrement situé à l'aplomb des 25%, par exemple des 20%, par exemple des 10% de la longueur de la bande les plus éloignés de la deuxième extrémité de ladite bande conductrice inférieure (201), et le deuxième via (205B) est entièrement situé à l'aplomb des 25%, par exemple des 20%, par exemple des 10% de la longueur de la bande conductrice inférieure (201) les plus éloignés de la première extrémité de ladite bande conductrice inférieure (201).

12. Dispositif (216 ; 316) selon l'une quelconque des revendications 1 à 11 dans lequel les bandes conductrices inférieures (201) sont en silicium.

13. Dispositif (216 ; 316) selon l'une quelconque des revendications 1 à 12, formé dans et sur un substrat semiconducteur (101), dans lequel le substrat semiconducteur (101) comporte une partie (101P) dopée d'un premier type de conductivité, les bandes conductrices inférieures (201) étant entièrement formées dans ladite partie (101P) du substrat semiconducteur (101).

14. Dispositif (216 ; 316) selon l'une quelconque des revendications 1 à 13, dans lequel les bandes conductrices inférieures (201, 201', 201'') sont séparées deux à deux par des tranchées d'isolation (202).

15. Dispositif (216 ; 316) selon l'une quelconque des revendications 1 à 14 dans lequel chaque bande conductrice inférieure (201) est séparée d'une bande conductrice inférieure (201') voisine d'une distance comprise entre 5 nm et 10 µm.

16. Dispositif (216 ; 316) selon l'une quelconque des revendications 1 à 15, dans lequel chaque bande conductrice supérieure (203) est séparée d'une bande conductrice supérieure (203') voisine d'une distance comprise entre 20 nm et 10 µm.

17. Puce électronique comprenant au moins un dispositif de détection de fissure (216 ; 316) selon l'une quelconque des revendications 1 à 16, la puce étant délimitée par un bord (110), le dispositif de détection de fissures (216 ; 316) étant disposé entre le bord (110) de la puce électronique (200) et une région de circuits électroniques (105) de la puce électronique.

18. Puce selon la revendication 17, comprenant plusieurs dispositifs de détection de fissure (216 ; 316) selon l'une quelconque des revendications 1 à 16.

19. Procédé de fabrication d'une puce électronique, comprenant une étape de formation d'un dispositif de détection de fissures (216 ; 316) selon l'une quelconque des revendications 1 à 16.

20. Procédé d'utilisation d'une puce électronique selon la revendication 17 ou 18, comportant une étape de test de conductivité électrique du dispositif de détection de fissures.
